(19) **Europäisches Patentamt / European Patent Office / Office européen des brevets**

(11) **EP 1 215 795 B1**

(12) **EUROPEAN PATENT SPECIFICATION**

(45) Date of publication and mention
of the grant of the patent:
**13.10.2010 Bulletin 2010/41**

(51) Int Cl.:
***G01R 31/36*** *(2006.01)* ***H02J 7/00*** *(2006.01)*

(21) Application number: **01309562.5**

(22) Date of filing: **13.11.2001**

(54) **Apparatus for and method of detecting charge state of vehicle battery**

Vorrichtung und Verfahren zur Detektierung des Ladezustands der Fahrzeugbatterie

Appareil et méthode pour détecter l'état de charge de la batterie d'un véhicule

(84) Designated Contracting States:
**DE FR GB**

(30) Priority: **13.12.2000 JP 2000378381**

(43) Date of publication of application:
**19.06.2002 Bulletin 2002/25**

(73) Proprietor: **NISSAN MOTOR COMPANY LIMITED
Yokohama-shi Kanagawa 221-0023 (JP)**

(72) Inventor: **Ikeda, Sadafumi
Chigasaki-shi,
Kanagawa (JP)**

(74) Representative: **Oxley, Robin John George et al
Marks & Clerk LLP
90 Long Acre
London
WC2E 9RA (GB)**

(56) References cited:
**US-A- 5 773 962**

Printed by Jouve, 75001 PARIS (FR)

## Description

The present invention relates to an apparatus for and a method of detecting the charge state of a vehicle battery that can be charged/discharged.

A battery that can be charged/discharged is normally mounted on a vehicle to function as a power supply source from which power is supplied to an electrical load of the vehicle. This battery is charged by a generator while the vehicle travels. The electrical load of the vehicle is driven by the power charged in the battery. However, battery depletion occurs due to an insufficient quantity of power in the battery if the quantity of power charged in the battery becomes low after power is discharged to the electrical load from the battery or if the battery becomes degraded. In order to ensure that such battery depletion is prevented by giving the driver advance warning that battery depletion is imminent, the vehicle is equipped with a warning lamp which warns that the quantity of power charged in the battery has become low and a meter which indicates the charge quantity representing the quantity of power stored in the battery.

The following method is normally adopted in the earlier technology to detect the charge state of a battery. Namely, the battery charge state is ascertained by measuring the voltage at the battery, the battery charge state thus ascertained is set as an initial value and the battery charge state is subsequently calculated as necessary by totalizing the charge / discharge quantity as the vehicle travels.

However, since a battery manifests characteristics whereby the potential achieves a state of equilibrium when a specific length of time has elapsed following a battery charge / discharge, an accurate battery charge state cannot be detected until the specific length of time elapses following the battery charge / discharge. For this reason, if the battery voltage is measured before the specific length of time elapses following a battery charge / discharge, an accurate battery charge state cannot be detected based upon the measured voltage. In such a case, a problem arises in that an error between the actual battery charge state and the detected battery charge state manifests. In other words, even when the quantity of power actually charged in the battery is nearing zero, the warning lamp or the meter may indicate that there is still some margin of safety left with regard to the battery charge quantity. In addition, the warning lamp or the meter may erroneously indicate that the battery charge quantity is nearing zero even when a comfortable margin remains with regard to the actual battery charge quantity.

Japanese Laid-Open Patent Publication No. H 8-106927 discloses an apparatus for detecting the charge state of a vehicle battery by addressing the problem discussed above. This apparatus in the prior art for detecting the vehicle battery charge state is provided with a timer that counts the length of time elapsing after the battery stops charging, and it measures the voltage at the battery after it is detected by the timer that a predetermined length of time after which the potential is assumed to enter a state of equilibrium has elapsed. As a result, the battery charge state is detected with a high degree of accuracy.

US 5773962 discloses a circuit arrangement to monitor the energy stored in a chain of batteries based upon voltage readings of the batteries and current readings of the circuit arrangement.

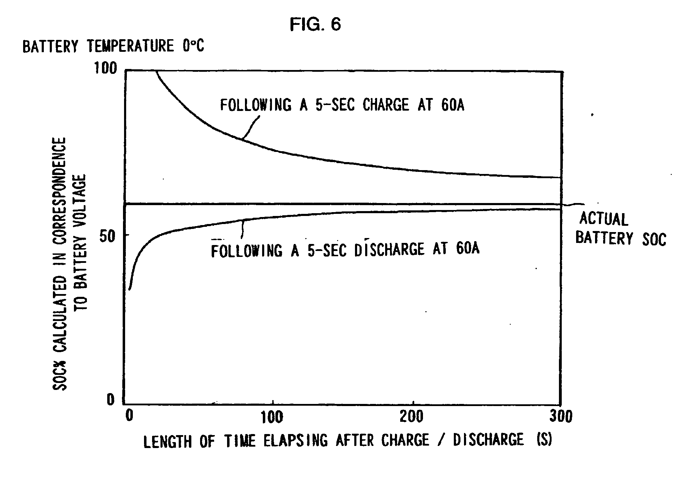

However, the vehicle battery charge state detection apparatus in the prior art poses a problem in that the efficiency with which the battery charge state is detected is poor. This problem is now explained in detail in reference to FIGS. 6 ~ 8.

FIG. 6 shows the relationship ascertained through testing, which manifests between the battery charge state (SOC: state of charge) calculated in conformance to the battery voltage following a battery charge / discharge and the length of time elapsing after the battery charge / discharge with the battery temperature set to 0 °C. The battery charge and discharge are both implemented by using a 60 (A) current over 5 seconds. As FIG. 6 clearly indicates, the length of time to elapse before the battery charge state calculated based upon the battery voltage matches the actual battery charge state following the battery charge differs from the length of time to elapse before the calculated battery charge state matches the actual battery charge state following the battery discharge. Namely, since the length of time to elapse following the battery charge before the battery voltage enters a state of equilibrium does not match the length of time to elapse following the battery discharge before the battery voltage enters a state of equilibrium, the length of time to elapse following the battery charge before the calculated battery charge state matches the actual battery charge state, too, is different from the length of time to elapse following the battery discharge before the calculated battery charge state matches the actual battery charge state.

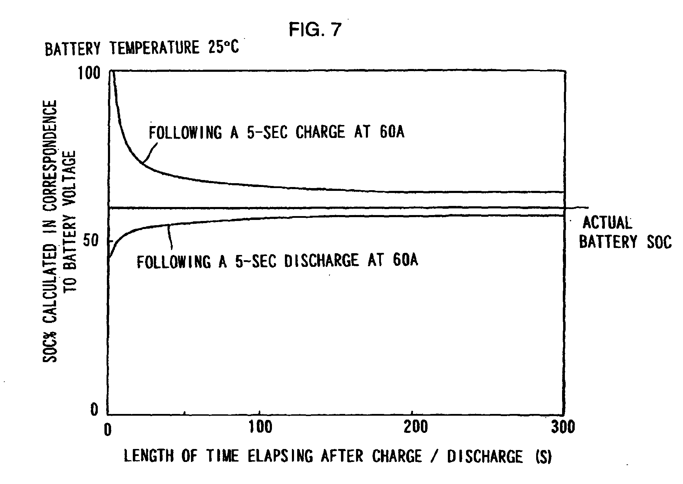

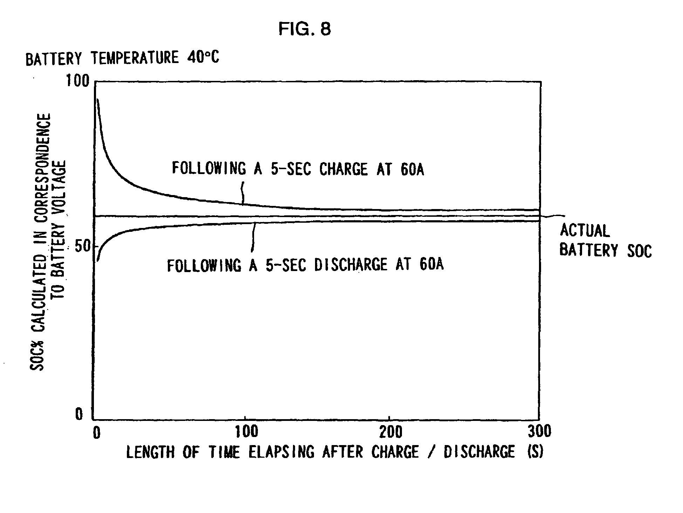

FIGS. 7 and 8 present the results of identical tests conducted by varying the battery temperature. FIG. 7 presents the results of a test conducted by setting the battery temperature at 25°C, whereas FIG. 8 presents the results of a test conducted by setting the battery temperature at 40°C. As the results presented in FIGS. 6 ~ 8 clearly indicate, the length of time to elapse following the battery charge / discharge before the battery voltage enters a state of equilibrium changes depending upon the battery temperature.

In other words, the length of time to elapse following the battery charge or discharge before the battery potential enters a state of equilibrium, i.e., the length of time to elapse before the battery charge state can be calculated with accuracy, changes depending upon conditions including the battery temperature and whether the battery has undergone a charge or discharged. Accordingly, the time setting at the timer mentioned earlier must be the maximum value selected by taking into consideration these conditions. However, this may lead to a problem in that the battery charge state can only be detected after the length of time set at the timer elapses even when the battery potential has already entered equilibrium. In other words, the efficiency with which the battery charge state is detected may be compromised.

It would be desirable to be able to provide an apparatus for and a method of detecting the charge state of a vehicle battery, that make it possible to accurately detect the battery charge state within the shortest possible length of time corresponding to the battery conditions.

A vehicle battery charge state detection apparatus according to the present invention comprises a charge state detection means for detecting the charge state of a vehicle battery which can be charged and discharged, a battery temperature detection means for detecting the temperature of the battery, an ambient temperature detection means for detecting the ambient temperature and an equilibrium judging means for judging as to whether or not the battery potential is in a state of equilibrium or in a state of non-equilibrium based upon the battery temperature detected by the battery temperature detection means and the ambient temperature detected by the ambient temperature detection means. The equilibrium judging means judges that the potential at said battery is in the state of equilibrium if a temperature difference between the battery temperature and the ambient temperature is equal to or smaller than a predetermined value, and judges that the potential at said battery is in the state of non-equilibrium if the temperature difference between the battery temperature and the ambient temperature is larger than the predetermined value. The charge state detection means detects the battery charge state if the equilibrium judging means judges that the battery potential is in a state of equilibrium but does not detect the battery charge state if the equilibrium judging means judges that the battery potential is in a state of non-equilibrium.

In the method of detecting the charge state of a vehicle battery which can be charged / discharged, the battery temperature and the ambient temperature are detected, it is judged as to whether the battery potential is in a state of equilibrium or non-equilibrium based upon the detected battery temperature and ambient temperature; and the battery charge state is detected if the battery potential is in a state of equilibrium whereas the battery charge state is not detected if the battery potential is determined to be in a state of non-equilibrium, wherein the potential at said battery is determined to be in a state of equilibrium if a temperature difference between the battery temperature and the ambient temperature is equal to or smaller than a predetermined value, and the potential at said battery is determined to be in the state of non equilibrium if the temperature difference between the battery temperature and the ambient temperature is larger than the predetermined value.

BRIEF DESCRIPTION OF THE DRAWINGS

FIG. 1 is a block diagram illustrating the structure adopted in an embodiment of the vehicle battery charge state detection apparatus according to the present invention;

FIG. 2 is a block diagram illustrating the structure adopted in the control unit 7 in the embodiment;

FIG. 3 is a flowchart of the processing implemented by the control unit 7 after the ignition key is turned off;

FIG. 4 is a flowchart of the processing implemented by the control unit 7 after the ignition key is turned on;

FIG. 5 shows a judging value determining table utilized to calculate the judging value Tc or Td;

FIG. 6 shows the relationship ascertained through testing, which manifests between the battery charge state (SOC) calculated based upon the battery voltage and the length of time elapsing following a charge / discharge when a 60A current is charged / discharged over 5 seconds with the battery temperature set to 0°C;

FIG. 7 shows the relationship ascertained through testing, which manifests between the battery charge state (SOC) calculated based upon the battery voltage and the length of time elapsing following a charge / discharge when a 60A current is charged / discharged over 5 seconds with the battery temperature set to 25 °C; and

FIG. 8 shows the relationship ascertained through testing, which manifests between the battery charge state (SOC) calculated based upon the battery voltage and the length of time elapsing following a charge / discharge when a 60A current is charged / discharged over 5 seconds with the battery temperature set to 40°C.

DETAILED DESCRIPTION OF THE PREFERRED EMBODIMENT

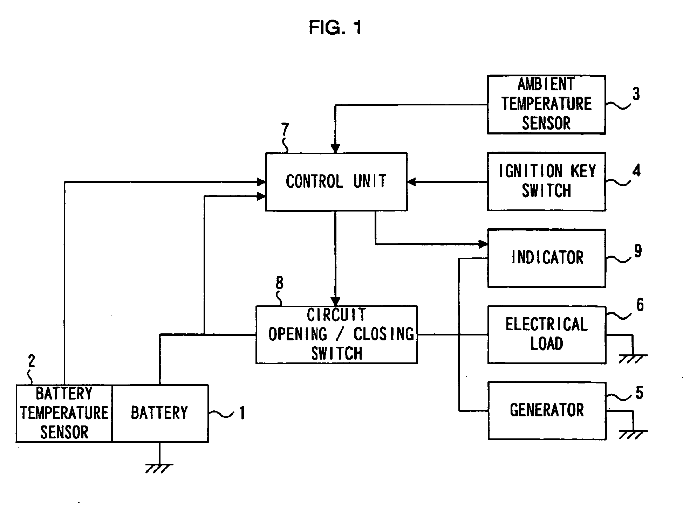

The following is a detailed explanation of an embodiment of the vehicle battery charge state detection apparatus according to the present invention, given in reference to FIGS. 1 through 5. FIG. 1 is a block diagram showing the structure adopted in an embodiment of the vehicle battery charge state detection apparatus according to the present invention. A battery 1 that can be charged / discharged is mounted in a vehicle. The battery 1 is connected to an electrical load 6 which may be a lamp or a motor fan in the vehicle, a generator 5, and an indicator 9 that indicates the charge state of the battery 1. The battery 1 is charged by utilizing the generator 5. The electrical load 6 and the indicator 9 are driven by the power supplied from the battery 1.

A circuit opening / closing switch 8 is provided between the battery 1 and the electrical load 6, the generator 5, and the indicator 9. The circuit opening / closing switch 8 electrically connects the battery 1 to the electrical load 6 and the generator 5 by closing the circuit in response to a switch close signal provided by the control unit 7. In addition, it electrically disconnects the battery 1 from the electrical load 6 and the generator 5 by opening the circuit in response to a switch open signal provided by the control unit 7.

A battery temperature sensor 2, which may be provided in the vicinity of the battery 1, for instance, detects the temperature of the battery 1. An ambient temperature sensor 3 detects the ambient temperature around the battery (1). An ignition key switch 4 is turned on when the driver inserts a vehicle key (not shown) at an ignition key cylinder and turns the vehicle key to the ON position and is turned off when the vehicle key (not shown) is turned to the OFF position. The ignition key switch 4 transmits an ON signal indicating an ON state and an OFF signal indicating an OFF state to the control unit 7. By detecting the ON/OFF state of the ignition key switch 4, a time point at which the driver stops the vehicle (the engine) and a time point at which the driver starts the vehicle (the engine) can be detected with a high degree of accuracy.

The indicator 9 signals the charge state of the battery 1 to the driver. The indicator 9, which may be provided in, for instance, the speedometer, signals the charge state of the battery 1 transmitted from the control unit 7. The control unit 7 is connected to the battery 1, the battery temperature sensor 2, the ambient temperature sensor 3, the ignition key switch 4, the circuit opening / closing switch 8, and the indicator 9. The control unit 7 detects the charge state of the battery 1 based upon the voltage at the battery 1, the battery temperature detected by the battery temperature sensor 2, and the ambient temperature detected by the ambient temperature sensor 3. The battery charge state thus detected is transmitted to the indicator 9. The control unit 7 also engages in control for opening / closing the circuit opening / closing switch 8.

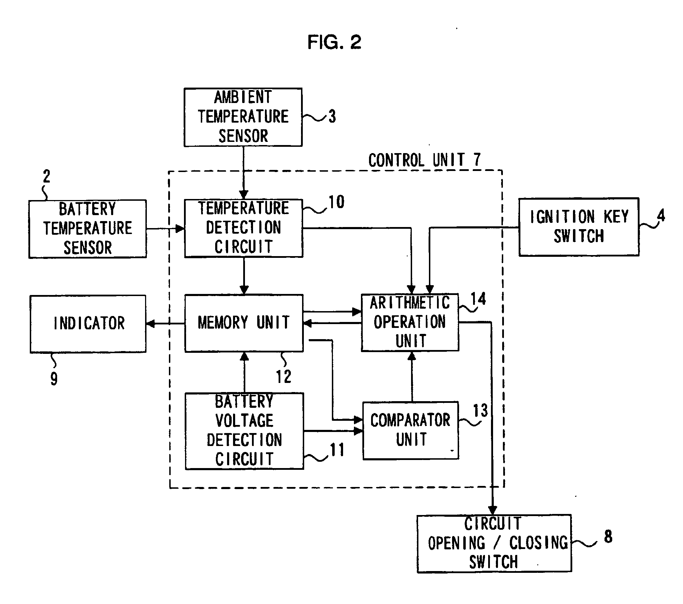

The structure adopted in the control unit 7 is now explained in reference to FIG. 2. The control unit 7 includes a temperature detection circuit 10, a battery voltage detection circuit 11, a memory unit 12, a comparator unit 13 and an arithmetic operation unit 14. The battery voltage detection circuit 11 detects the voltage at the battery 1 and converts the voltage at the battery 1 that has been detected to a battery voltage value to be used in an arithmetic operation. The temperature detection circuit 10 converts the battery temperature detected by the battery temperature sensor 2 and the ambient temperature detected by the ambient temperature sensor 3 to a battery temperature value and an ambient temperature value respectively to be utilized in the arithmetic operation.

The memory unit 12 stores in memory the battery temperature value obtained through the conversion performed at the temperature detection circuit 10 and the battery voltage value detected at the battery voltage detection circuit 11, and also stores in memory the battery charge state transmitted from the arithmetic operation unit 14. The battery charge state stored in the memory unit 12 is transmitted to the indicator 9 in response to a command issued by the arithmetic operation unit 14.

The comparator unit 13 reads out the battery voltage value stored in the memory unit 12 and the battery voltage value detected at the battery voltage detection circuit 11 and judges as to whether the battery 1 has undergone a charge or discharge by comparing the two battery voltage values thus read out. The judging results are transmitted to the arithmetic operation unit 14. The arithmetic operation unit 14 reads out the battery temperature value and the battery voltage value stored in the memory unit 12, and judges as to whether the battery potential is in a state of equilibrium or in a state of non-equilibrium based upon the battery temperature value and the battery voltage value that have been read out, the judging results transmitted from the comparator unit 13 and the battery temperature value and the ambient temperature value read out from the temperature detection circuit 10. If it is decided that the battery potential is in a state of equilibrium, the arithmetic operation unit 14 detects the battery charge state and transmits the detected charge state to the memory unit 12, whereas the arithmetic operation unit 14 does not detect the battery charge state if the battery potential is detected to be in a state of non-equilibrium.

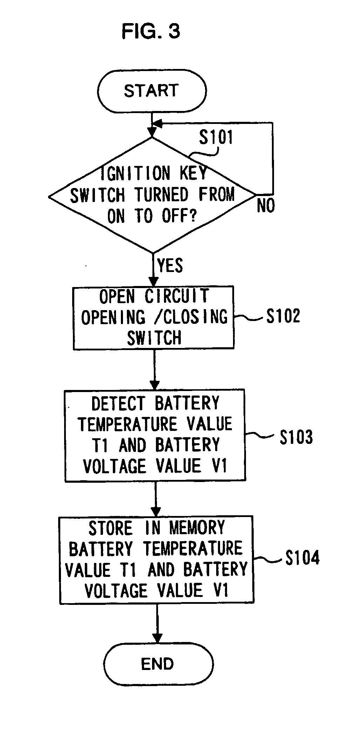

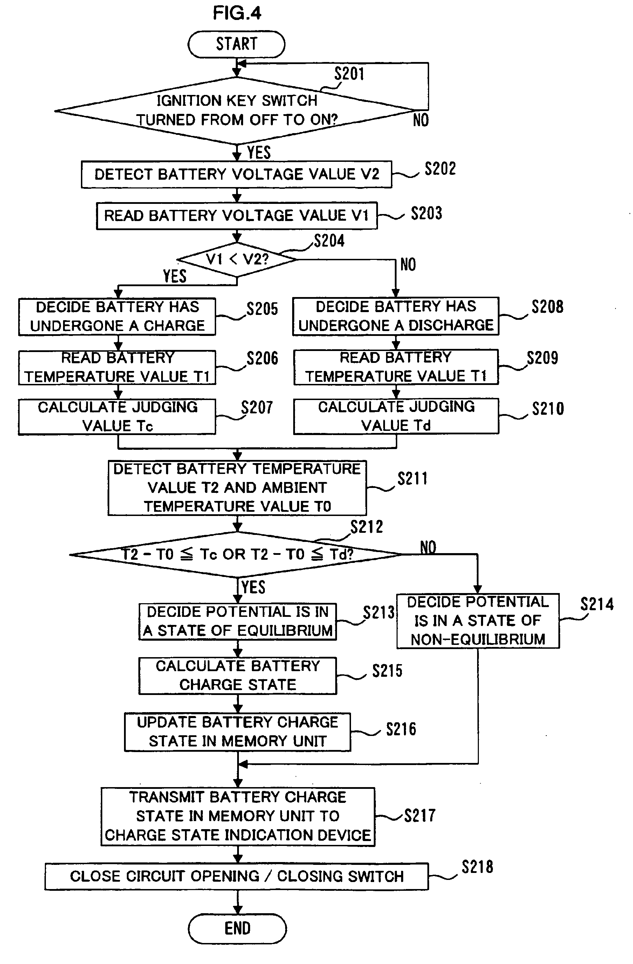

Now, the details of the control implemented by the control unit 7 are explained in reference to the flowcharts presented in FIGS. 3 and 4. The flowchart in FIG. 3 shows the details of the control implemented by the control unit 7 when the driver stops the vehicle, i.e. when the driver stops the engine.

In step S101, it is judged as to whether or not the driver has stopped the vehicle, i.e. as to whether or not the ignition key switch 4 has been switched from an ON state to an OFF state. If the driver has turned the vehicle key (not shown) to turn off the ignition key switch 4, an OFF signal is provided to the arithmetic operation unit 14. Upon receiving the OFF signal at the arithmetic operation unit 14, it is decided that the ignition key switch 4 has been switched from the ON state to the OFF state and the operation proceeds to step S102. The arithmetic operation unit 14 transmits a switch open signal to the circuit opening / closing switch 8 in step S102. Upon receiving the switch open signal, the circuit opening / closing switch 8 electrically disconnects the battery 1 from the generator 5 and the electrical load 6 by opening the circuit.

In step S103, the temperature detection circuit 10 converts the battery temperature detected at the battery temperature sensor 2 to a battery temperature value T1. In addition, the battery voltage detection circuit 11 detects a battery voltage value V1. Once the battery temperature value T1 and the battery voltage value V1 are detected, the operation proceeds to step S104. In step S104, the battery temperature value T1 and the battery voltage value V1 detected in step S103 are stored in the memory unit 12.

When the battery temperature value T1 and the battery voltage value V1 are stored in the memory unit 12 after the driver stops driving the vehicle, the control for detecting the battery charge state ends for the time being.

Next, the details of the control implemented by the control unit 7 when the driver starts the vehicle, i.e. when the driver starts the engine, are explained in reference to the flowchart presented in FIG. 4. In step S201, it is judged as to whether or not the driver has started the vehicle, i.e., as to whether or not the ignition key switch 4 has exited the OFF state and entered the ON state. If the driver has turned the vehicle key (not shown) to turn on the ignition key switch 4, an ON signal is provided to the arithmetic operation unit 14. Upon receiving the ON signal at the arithmetic operation unit 14, it is decided that the ignition key switch 4 has been switched from the OFF state to the ON state and the operation proceeds to step S202.

In step S202, the battery voltage detection circuit 11 detects a battery voltage value V2 before the operation proceeds to step S203. In step S203, the comparator unit 13 reads out the battery voltage value V1 that was stored in the memory unit 12 when the vehicle was stopped previously. Once the battery voltage value V1 is read out, the operation proceeds to step S204. In step S204, the comparator unit 13 compares the battery voltage value V2 detected at the battery voltage detection circuit 11 with the battery voltage value V1 read out from the memory unit 12. If it is decided that the battery voltage value V1 is smaller than the battery voltage value V2, the operation proceeds to step S205.

In step S205, the comparator unit 13 decides that the battery 1 has undergone a charge and provides the results of the decision to the arithmetic operation unit 14 before the operation proceeds to step S206. In step S206, the arithmetic operation unit 14 reads the battery temperature value T1 that was stored in the memory unit 12 when the vehicle was last stopped (step S104 in FIG. 3). Once the battery temperature value T1 is read, the operation proceeds to step S207. In step S207, the arithmetic operation unit 14 calculates a judging value Tc which is to be detailed later.

If, on the other hand, it is decided in step S204 that the battery voltage value V1 is larger than the battery voltage value V2, the operation proceeds to step S208. In step S208, the comparator unit 13 decides that the battery 1 has undergone a discharge and provides the results of the decision to the arithmetic operation unit 14 before the operation proceeds to step S209. In step S209, the arithmetic operation unit 14 reads the battery temperature value T1 that was stored in the memory unit 12 when the vehicle was last stopped (step S104 in FIG.3). Once the battery temperature value T1 is read, the operation proceeds to step S210. In step S210, the arithmetic operation unit 14 calculates a judging value Td which is to be detailed later.

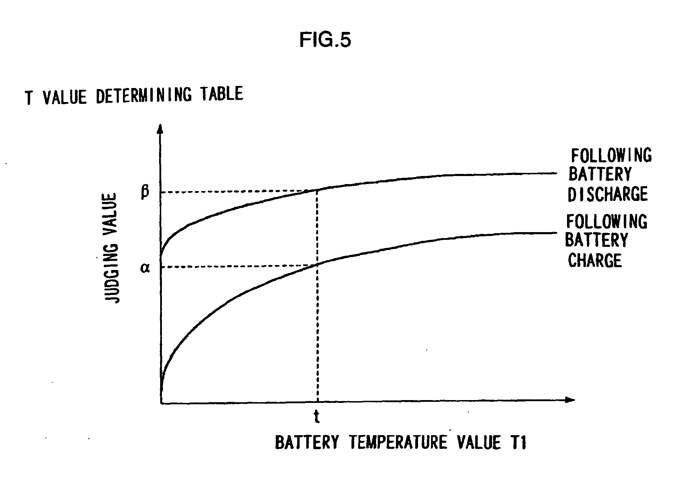

An explanation is given on the method of calculating the judging value Tc which is calculated in step S207 to be utilized after deciding that a charge has been performed and the judging value Td calculated in step S210 to be used after deciding that a discharge has been performed. The arithmetic operation unit 14 includes a table of data indicating the relationship between the battery temperature value T1 and the judging values Tc and Td, which is ascertained in advance through testing, as shown in FIG. 5. As FIG. 5 indicates, when the battery temperature value T1 = t, for instance, the judging value Tc calculated after deciding that the battery has undergone a charge is $\alpha$ and the judging value Td calculated after deciding that the battery has undergone a discharge is $\beta$. Namely, the judging value Tc or Td is calculated based upon the battery temperature value T1 read in step S206 or step S209 and the table shown in FIG. 5. After calculating the judging value Tc or Td in step S207 or step S210, the operation proceeds to step S211. It is to be noted that the judging value Tc or Td is utilized in the processing implemented in step S212 which is to be detailed later.

In step S211, the temperature detection circuit 10 detects a battery temperature value T2 which is the current battery temperature value and an ambient temperature value T0 that is the current ambient temperature value. The arithmetic operation unit 14 reads the battery temperature value T2 and the ambient temperature value T0 from the temperature detection circuit 10 and then the operation proceeds to step S212.

If it has been decided in step S205 that the battery 1 has undergone a charge, it is judged in step S212 as to whether the difference between the battery temperature value T2 and the ambient temperature value T0 is equal to or smaller than the judging value Tc. If, on the other hand, it has been decided in step S208 that the battery 1 has undergone a discharge, it is judged in step S212 as to whether the difference between the battery temperature value T2 and the ambient temperature value T0 is equal to or smaller than the judging value Td. For instance, if it is decided in step S205 that the battery 1 has undergone a charge when the battery temperature T1 = t, it is judged as to whether or not the relationship expressed in the following expression (1) is achieved.

$$T2 - T0 \leqq \alpha \quad \ldots \quad (1)$$

If, on the other hand it is decided in step S208 that the battery 1 has undergone a discharge, it is judged as to whether or not the relationship expressed in the following expression (2) is achieved.

$$T2 - T0 \leqq \beta \quad \ldots \quad (2)$$

If it is decided that the relationship expressed in expression (1) or expression (2) is achieved, the operation proceeds to step S213. In step S213, the arithmetic operation unit 14 decides that the battery potential is in a state of equilibrium and the operation proceeds to step S215. In step S215, the arithmetic operation unit 14 calculates the battery charge state in correspondence to the battery voltage value V2. The results of the calculation are transmitted to the memory unit 12. In the following step S216, the memory unit 12 updates the charge state by storing in memory the battery charge state transmitted from the arithmetic operation unit 14. Namely, since the charge state of the battery 1 is updated only if the potential at the battery 1 is in a state of equilibrium, it is ensured that the charge state of the battery 1 stored in the memory unit 12 is an accurate value at all times. Once the charge state of the battery 1 is stored in memory, the operation proceeds to step S217.

If, on the other hand, it is decided in step S212 that the relationship expressed in expression (1) or (2) is not achieved, the operation proceeds to step S214. It is generally known that the battery 1 generates heat when the potential at the battery 1 is in a state of non-equilibrium. Accordingly, if the difference between the battery temperature value T2 and the ambient temperature value T0 is larger than the judging value Tc or Td, the potential at the battery 1 is determined to be in a state of non-equilibrium. Namely, in step S214, the arithmetic operation unit 14 decides that the battery potential is in a state of non-equilibrium and the operation proceeds to step S217.

In step S217, the battery charge state stored in step S216 is transmitted from the memory unit 12 to the indicator 9. Thus, an accurate charge state of the battery 1 can be indicated to the driver. In the following step S218, the arithmetic operation unit 14 transmits a switch close signal to the circuit opening / closing switch 8. Upon receiving the switch close signal, the circuit opening / closing switch 8 closes the circuit.

The vehicle battery charge state detection apparatus according to the present invention described above detects the battery charge state as summarized below. When the ignition key switch 4 is switched from an ON state to an OFF state, the temperature detection circuit 10 detects the battery temperature value T1 and the battery voltage detection circuit 11 detects the battery voltage value V1, both of which are then stored in the memory unit 12. When the ignition key switch 4 is subsequently turned on from the OFF state, the battery voltage detection circuit 11 detects the battery voltage value V2. The comparator unit 13 judges as to whether the battery 1 has undergone a charge or discharge by comparing the battery voltage value V1 read out from the memory unit 12 with the battery voltage value V2. Regardless of whether the battery 1 is determined to have been charged or discharged, the battery temperature value T1 stored in the memory unit 12 is read out and the judging value Tc or Td is calculated based upon the battery temperature value T1 thus read out. The arithmetic operation unit 14 judges as to whether the battery potential is in a state of equilibrium or in a state of non-equilibrium based upon the current battery temperature value T2, the current ambient temperature value T0 and the judging value Tc or Td. Only if it is decided that the battery potential is in a state of equilibrium, the arithmetic operation unit 14 detects the charge state of the battery 1 in correspondence to the battery voltage value V2 and updates the charge state of battery 1 stored in the memory unit 12. The charge state of the battery 1 stored in the memory unit 12 is transmitted to the indicator 9.

As a result, it becomes possible to detect the charge state of the battery 1 when the potential at the battery 1 enters a state of equilibrium and therefore to accurately detect the charge state of the battery 1 within the shortest possible period of time following a charge / discharge of the battery 1. In addition, the timer provided in the apparatus for detecting the battery charge state in the prior art described earlier is no longer required. Thus, the battery charge state can be detected with a high degree of accuracy with no timer consuming power from the battery 1. Furthermore, a reduction in the production costs is achieved, since it is not necessary to provide the timer.

The arithmetic operation unit 14 decides that the potential at the battery 1 is in a state of equilibrium if the difference between the battery temperature value T2 and the ambient temperature value T0 is equal to or smaller than the judging value Tc or Td and decides that the potential at the battery 1 is in a state of non-equilibrium if the difference between the battery temperature value T2 and the ambient temperature value T0 is larger than the judging value Tc or Td. Since the judging values Tc and Td are each calculated based upon the battery temperature value T1, the charge state of the battery 1 can be detected with a high degree of accuracy within the shortest possible length of time following the charge / discharge of the battery 1 even when the battery temperature fluctuates.

The judging value Tc or Td is calculated based upon the battery temperature value T1 detected when the driver last stopped the vehicle and the battery temperature value T2 and the ambient temperature value T0 are detected when the driver restarts the vehicle. Consequently, the charge state of the battery 1 can be detected as the driver restarts the vehicle. Thus, it is ensured that an accurate charge state of the battery can be detected whenever the vehicle is started.

In addition, the judging value Tc or Td is calculated based upon the results of the comparison of the battery voltage value V1 detected when the driver last stopped the vehicle and the battery voltage value V2 detected when the driver restarts the vehicle in addition to the battery temperature value T1. As a result, the judging value Tc or Td can be calculated with an even higher degree of accuracy to achieve an even more accurate detection of the charge state of the battery 1.

The present invention is not limited to the embodiment presented above. For instance, a table other than that shown in FIG. 5 may be used to calculate the judging values Tc and Td. In addition, the charge state of the battery 1 may be indicated to the driver with a buzzer (not shown) instead of the indicator 9.

**Claims**

1. A vehicle battery charge state detection apparatus comprising:

    charge state detection means (14) for detecting a charge state of a vehicle battery (1) which can be charged/discharged;
    battery temperature detection means (2, 10) for detecting a temperature of said battery (1);
    ambient temperature detection means (3, 10) for detecting an ambient temperature; and
    equilibrium judging means (14) for judging as to whether a potential at said battery (1) is in a state of equilibrium or in a state of non-equilibrium based upon the battery temperature detected by said battery temperature detection means (2, 10) and the ambient temperature detected by said ambient temperature detection means (3, 10), wherein:

        said equilibrium judging means (14) judges that the potential at said battery (1) is in the state of equilibrium if a temperature difference between the battery temperature and the ambient temperature is equal to or smaller than a predetermined value, and judges that the potential at said battery (1) is in the state of non-equilibrium if the temperature difference between the battery temperature and the ambient temperature is larger than the predetermined value; and said charge state detection means (14) detects the charge state of said battery (1) if said equilibrium judging means (14) judges that the potential at said battery (1) is in a state of equilibrium but does not detect the charge state of said battery (1) if said equilibrium judging means (14) judges that the potential at said battery (1) is in a state of non-equilibrium.

2. A vehicle battery charge state detection apparatus according to claim 1, wherein:

    the battery temperature and the ambient temperature are both detected when starting to drive the vehicle.

3. A vehicle battery charge state detection apparatus according to claim 1 or 2, wherein:

    the predetermined value is calculated based upon a battery temperature detected by the battery temperature detection means (2, 10) when stopping to drive the vehicle.

4. A vehicle battery charge state detection apparatus according to any of claims 1 to 3 further comprising:

    a charge/discharge judging means (13) for judging as to whether said battery (1) has undergone a charge or discharge, wherein:

        the predetermined value is calculated based upon the judging results by said charge/discharge judging means (13) in addition to a battery temperature detected by said battery temperature detection means (2, 10) when stopping to drive the vehicle.

5. A vehicle battery charge state detection apparatus according to claim 4, further comprising:

    a battery voltage detection means (11) for detecting a voltage of said battery (1), wherein:

        said charge/discharge judging means (13) judges as to whether said battery (1) has undergone a charge or discharge based upon a battery voltage detected by said battery voltage detection means (13) when the driver last stopped the vehicle and a battery voltage detected by said battery voltage detection means (13) when the driver starts the vehicle.

6. A vehicle battery charge state detection apparatus according to any of claims 2 to 5, wherein:

    the vehicle is assumed to have been stopped to drive when the ignition key switch is switched from an ON state to an OFF state; and
    the vehicle is assumed to have been started to drive when the ignition key switch is switched from an OFF state to an ON state.

7. A vehicle battery charge state detection apparatus according to any of claims 1 to 6, further comprising:

    storage means (12) for storing in memory the charge state of said battery (1), wherein:

        said storage means (12) updates the charge state stored in said storage means (12) if said charge state detection means (14) detects the charge state of said battery (1); and

said storage means (12) does not update the charge state stored in said storage means (12) if said charge state detection means (14) does not detect the charge state of said battery (1).

8. A vehicle battery charge state detection apparatus according to claim 7, further comprising:

indication means (9) for indicating the charge state of said battery (1) stored in said storage means (12).

9. A method of detecting a charge state of a vehicle battery that can be charged/discharged, comprising:

detecting a temperature of said battery (1) and an ambient temperature;

judging as to whether a potential at said battery (1) is in a state of equilibrium or in a state of non-equilibrium based upon the temperature of said battery (1) and the ambient temperature that have been detected; and

detecting the charge state of said battery (1) if the potential at said battery (1) is determined to be in a state of equilibrium and not detecting the charge state of said battery (1) if the potential at said battery (1) is determined to be in a state of non-equilibrium, wherein

the potential at said battery (1) is determined to be in the state of equilibrium if a temperature difference between the battery temperature and the ambient temperature is equal to or smaller than a predetermined value, and the potential at said battery (1) is determined to be in the state of non-equilibrium if the temperature difference between the battery temperature and the ambient temperature is larger than the predetermined value.

## Patentansprüche

1. Fahrzeugbatterieladezustand- Detektionsvorrichtung, umfassend:

ein Ladezustand-Detektionsmittel (14) zum Detektieren eines Ladezustands einer Fahrzeugbatterie (1), die geladen/entladen werden kann;
Batterietemperatur-Detektionsmittel (2, 10) zum Detektieren einer Temperatur der Batterie (1);
Umgebungstemperatur-Detektionsmittel (3, 10) zum Detektieren einer Umgebungstemperatur; und
ein Gleichgewicht-Beurteilungsmittel (14) zum Beurteilen, ob ein Potential an der Batterie (1) in einem Gleichgewichtszustand oder in einem Ungleichgewichtszustand ist, basierend auf der Batterietemperatur, die von den Batterietemperatur-Detektionsmitteln (2, 10) detektiert wurde, und der Umgebungstemperatur, die von den Umgebungstemperatur-Detektionsmitteln (3, 10) detektiert wurde, wobei:

das Gleichgewicht-Beurteilungsmittel (14) beurteilt, dass das Potential an der Batterie (1) in dem Gleichgewichtszustand ist, wenn eine Temperaturdifferenz zwischen der Batterietemperatur und der Umgebungstemperatur gleich einem oder kleiner als ein im Voraus bestimmter Wert ist, und beurteilt, dass das Potential an der Batterie (1) in dem Ungleichgewichtszustand ist, wenn die Temperaturdifferenz zwischen der Batterietemperatur und der Umgebungstemperatur größer als der im Voraus bestimmte Wert ist; und

das Ladezustand-Detektionsmittel (14) den Ladezustand der Batterie (1) detektiert, wenn das Gleichgewicht-Beurteilungsmittel (14) beurteilt, dass das Potential an der Batterie (1) in dem Gleichgewichtszustand ist, aber den Ladezustand der Batterie (1) nicht detektiert, wenn das Gleichgewicht-Beurteilungsmittel (14) beurteilt, dass das Potential an der Batterie (1) in einem Ungleichgewichtszustand ist.

2. Fahrzeugbatterieladezustand- Detektionsvorrichtung nach Anspruch 1, wobei:

die Batterietemperatur und die Umgebungstemperatur beide detektiert werden, wenn begonnen wird, das Fahrzeug zu fahren.

3. Fahrzeugbatterieladezustand- Detektionsvorrichtung nach Anspruch 1 oder 2, wobei:

der im Voraus bestimmte Wert basierend auf einer Batterietemperatur berechnet wird, die von den Batterietemperatur-Detektionsmitteln (2, 10) detektiert wird, wenn aufgehört wird, das Fahrzeug zu fahren.

4. Fahrzeugbatterieladezustand- Detektionsvorrichtung nach einem der Ansprüche 1 bis 3, weiter umfassend:

ein Ladungs-/Entladungs-Beurteilungsmittel (13) zum Beurteilen, ob die Batterie (1) einer Ladung oder Entladung unterzogen wurde, wobei:

der im Voraus bestimmte Wert basierend auf den Beurteilungsergebnissen durch das Ladungs-/ Entladungs- Beurteilungsmittel (13) zusätzlich zu einer Batterietemperatur, die von den Batterietemperatur-Detektionsmitteln (2, 10) detektiert wird, wenn aufgehört wird, das Fahrzeug zu fahren, berechnet wird.

5. Fahrzeugbatterieladezustand- Detektionsvorrichtung nach Anspruch 4, weiter umfassend:

ein Batteriespannung-Detektionsmittel (11) zum Detektieren einer Spannung der Batterie (1), wobei:

das Ladungs-/Entladungs-Beurteilungsmittel (13) beurteilt, ob die Batterie (1) einer Ladung oder Entladung unterzogen wurde, basierend auf einer Batteriespannung, die von dem Batteriespannung-Detektionsmittel (13) detektiert wurde, als der Fahrer das Fahrzeug zuletzt gestoppt hat, und einer Batteriespannung, die von dem Batteriespannung-Detektionsmittel (13) detektiert wird, wenn der Fahrer das Fahrzeug startet.

6. Fahrzeugbatterieladezustand- Detektionsvorrichtung nach einem der Ansprüche 2 bis 5, wobei:

angenommen wird, dass das Fahrzeug zu fahren aufgehört hat, wenn der Zündschlüsselschalter von einem EIN-Zustand in einen AUS-Zustand geschaltet wird; und
angenommen wird, dass das Fahrzeug zu fahren angefangen hat, wenn der Zündschlüsselschalter von einem AUS-Zustand in einen EIN-Zustand geschaltet wird.

7. Fahrzeugbatterieladezustand- Detektionsvorrichtung nach einem der Ansprüche 1 bis 6, weiter umfassend:

ein Speichermittel (12) zum Speichern des Ladezustands der Batterie (1) im Speicher, wobei:

das Speichermittel (12) den Ladezustand, der in dem Speichermittel (12) gespeichert ist, aktualisiert, wenn das Ladezustand-Detektionsmittel (14) den Ladezustand der Batterie (1) detektiert; und
das Speichermittel (12) den Ladezustand, der in dem Speichermittel (12) gespeichert ist, nicht aktualisiert, wenn das Ladezustand-Detektionsmittel (14) den Ladezustand der Batterie (1) nicht detektiert.

8. Fahrzeugbatterieladezustand- Detektionsvorrichtung nach Anspruch 7, weiter umfassend:

ein Anzeigemittel (9) zum Anzeigen des Ladezustands der Batterie (1), der in dem Speichermittel (12) gespeichert ist.

9. Verfahren zum Detektieren eines Ladezustands einer Fahrzeugbatterie, die geladen/entladen werden kann, umfassend:

Detektieren einer Temperatur der Batterie (1) und einer Umgebungstemperatur;
Beurteilen, ob ein Potential der Batterie (1) in einem Gleichgewichtszustand oder einem Ungleichgewichtszustand ist, basierend auf der Temperatur der Batterie (1) und der Umgebungstemperatur, die detektiert wurden; und
Detektieren des Ladezustands der Batterie (1), wenn bestimmt wird, dass das Potential an der Batterie (1) in einem Gleichgewichtszustand ist, und kein Detektieren des Ladezustands der Batterie (1), wenn bestimmt wird, dass das Potential an der Batterie (1) in einem Ungleichgewichtszustand ist, wobei
bestimmt wird, dass das Potential an der Batterie (1) in einem Gleichgewichtszustand ist, wenn eine Temperaturdifferenz zwischen der Batterietemperatur und der Umgebungstemperatur gleich einem oder kleiner als ein im Voraus bestimmter Wert ist, und bestimmt wird, dass das Potential an der Batterie (1) im Ungleichgewichtszustand ist, wenn die Temperaturdifferenz zwischen der Batterietemperatur und der Umgebungstemperatur größer als der im Voraus bestimmte Wert ist.

## Revendications

1. Appareil de détection d'état de charge de batterie de véhicule comprenant :

un moyen de détection d'état de charge (14) pour détecter un état de charge d'une batterie (1) de véhicule qui peut être chargée / déchargée ;
des moyens de détection de température de batterie (2, 10) pour détecter une température de ladite batterie (1) ;
des moyens de détection de température ambiante (3, 10) pour détecter une température ambiante ; et
un moyen de décision d'équilibre (14) qui décide si un potentiel au niveau de ladite batterie (1) est dans un état d'équilibre ou dans un état de non-équilibre en fonction de la température de batterie détectée par lesdits moyens de détection de température de batterie (2, 10) et de la température ambiante détectée par lesdits moyens de détection de température ambiante (3, 10), dans lequel ;

ledit moyen de décision d'équilibre (14) décide que le potentiel au niveau de ladite batterie (1) est à l'état d'équilibre si une différence de température entre la température de batterie et la température ambiante est égale ou inférieure à une valeur prédéterminée, et décide que le potentiel au niveau de ladite batterie (1) est à l'état de non-équilibre si la différence de température entre la température de batterie et la température ambiante est supérieure à la valeur prédéterminée ; et
ledit moyen de détection d'état de charge (14) détecte l'état de charge de ladite batterie (1) si ledit moyen de décision d'équilibre (14) décide que le potentiel au niveau de ladite batterie (1) est dans un état d'équilibre mais ne détecte pas l'état de charge de ladite batterie (1) si ledit moyen de décision d'équilibre (14) décide que le potentiel au niveau de ladite batterie (1) est dans un état de non-équilibre.

2. Appareil de détection d'état de charge de batterie de véhicule selon la revendication 1, dans lequel :

la température de batterie et la température ambiante sont toutes deux détectées lors du démarrage pour conduire le véhicule.

3. Appareil de détection d'état de charge de batterie de véhicule selon la revendication 1 ou 2, dans lequel :

la valeur prédéterminée est calculée en fonction d'une température de batterie détectée par les moyens de détection de température de batterie (2, 10) lorsque l'on arrête de conduire le véhicule.

4. Appareil de détection d'état de charge de batterie de véhicule selon l'une quelconque des revendications 1 à 3, comprenant en outre :

un moyen de décision de charge / décharge (13) pour décider si ladite batterie (1) a subi une charge ou une décharge, dans lequel :

la valeur prédéterminée est calculée en fonction des résultats de décision par ledit moyen de décision de charge / décharge (13) en plus d'une température de batterie détectée par lesdits moyens de détection de température de batterie (2, 10) lorsque l'on arrête de conduire le véhicule.

5. Appareil de détection d'état de charge de batterie de véhicule selon la revendication 4, comprenant en outre :

un moyen de détection de tension de batterie (11) pour détecter une tension de ladite batterie (1), dans lequel :

ledit moyen de décision de charge / décharge (13) décide si ladite batterie (1) a subi une charge ou une décharge en fonction d'une tension de batterie détectée par ledit moyen de détection de tension de batterie (13) lorsque le conducteur a arrêté le véhicule et d'une tension de batterie détectée par ledit moyen de détection de tension de batterie (13) lorsque le conducteur démarre le véhicule.

6. Appareil de détection d'état de charge de batterie de véhicule selon l'une quelconque des revendications 2 à 5, dans lequel :

le véhicule est supposé avoir été arrêté lorsque l'interrupteur de la clé de démarrage est passé d'un état de marche à un état d'arrêt ; et
le véhicule est supposé avoir été démarré lorsque l'interrupteur de la clé de démarrage passe d'un état d'arrêt à un état de marche.

7. Appareil de détection d'état de charge de batterie de véhicule selon l'une quelconque des revendications 1 à 6, comprenant en outre :

un moyen de mémorisation (12) pour stocker en mémoire l'état de charge de ladite batterie (1), dans lequel :

ledit moyen de mémorisation (12) met à jour l'état de charge mémorisé dans ledit moyen de mémorisation (12) si ledit moyen de détection d'état de charge (14) détecte l'état de charge de ladite batterie (1) ; et
ledit moyen de mémorisation (12) ne met pas à jour l'état de charge mémorisé dans ledit moyen de mémorisation (12) si ledit moyen de détection d'état de charge (14) ne détecte pas l'état de charge de ladite batterie (1).

8. Appareil de détection d'état de charge de batterie de véhicule selon la revendication 7, comprenant en outre :

un moyen d'indication (9) pour indiquer l'état de charge de ladite batterie (1) mémorisé dans ledit moyen de mémorisation (12).

9. Procédé pour détecter un état de charge d'une batterie de véhicule qui peut être chargée / déchargée, comprenant les étapes consistant à :

détecter une température de ladite batterie (1) et une température ambiante ;

décider si un potentiel au niveau de ladite batterie (1) est dans un état d'équilibre ou dans un état de non-équilibre en fonction de la température de ladite batterie (1) et de la température ambiante qui ont été détectées ; et

détecter l'état de charge de ladite batterie (1) si le potentiel au niveau de ladite batterie (1) est déterminé pour être dans un état d'équilibre et ne pas détecter l'état de charge de ladite batterie (1) si le potentiel au niveau de ladite batterie (1) est déterminé pour être dans un état de non-équilibre, dans lequel :

le potentiel au niveau de ladite batterie (1) est déterminé pour être à l'état d'équilibre si une différence de température entre la température de batterie et la température ambiante est égale ou inférieure à une valeur prédéterminée, et le potentiel au niveau de ladite batterie (1) est déterminé pour être à l'état de non-équilibre si la différence de température entre la température de batterie et la température ambiante est supérieure à la valeur prédéterminée.

FIG. 1

FIG. 2

## FIG. 3

```
        ┌─────────┐
        │  START  │
        └─────────┘
             │
             ▼
         ╱╲  ─── S101
        ╱   ╲
       ╱ IGNITION KEY ╲  NO
      ╱ SWITCH TURNED FROM ╲───┐
      ╲   ON TO OFF?   ╱       │
       ╲            ╱          │
        ╲         ╱            │
          ╲     ╱              │
            ╲ ╱                │
             │ YES             │
             ▼                 │
    ┌──────────────────┐       │
    │   OPEN CIRCUIT   │       │
    │ OPENING /CLOSING │── S102 │
    │     SWITCH       │       │
    └──────────────────┘       │
             │                 │
             ▼                 │
    ┌──────────────────┐       │
    │  DETECT BATTERY  │       │
    │ TEMPERATURE VALUE│       │
    │   T1 AND BATTERY │── S103 │
    │  VOLTAGE VALUE V1│       │
    └──────────────────┘       │
             │                 │
             ▼                 │
    ┌──────────────────┐       │
    │  STORE IN MEMORY │       │
    │ BATTERY TEMPERATURE│     │
    │ VALUE T1 AND BATTERY│─ S104│
    │  VOLTAGE VALUE V1│       │
    └──────────────────┘       │
             │                 │
             ▼                 │
        ┌─────────┐            │
        │   END   │            │
        └─────────┘            │
```

## FIG.4

START

S201

IGNITION KEY SWITCH
TURNED FROM OFF TO ON?  NO

YES

DETECT BATTERY VOLTAGE VALUE V2 — S202

READ BATTERY VOLTAGE VALUE V1 — S203

S204

V1 < V2?  NO

YES

DECIDE BATTERY HAS
UNDERGONE A CHARGE — S205

READ BATTERY
TEMPERATURE VALUE T1 — S206

CALCULATE JUDGING
VALUE Tc — S207

DECIDE BATTERY HAS
UNDERGONE A DISCHARGE — S208

READ BATTERY
TEMPERATURE VALUE T1 — S209

CALCULATE JUDGING
VALUE Td — S210

DETECT BATTERY TEMPERATURE
VALUE T2 AND AMBIENT
TEMPERATURE VALUE T0 — S211

S212

T2 − T0 ≦ Tc OR T2 − T0 ≦ Td?  NO

YES

DECIDE POTENTIAL IS IN
A STATE OF EQUILIBRIUM — S213

DECIDE POTENTIAL
IS IN A STATE OF
NON−EQUILIBRIUM — S214

CALCULATE BATTERY
CHARGE STATE — S215

UPDATE BATTERY CHARGE
STATE IN MEMORY UNIT — S216

TRANSMIT BATTERY CHARGE
STATE IN MEMORY UNIT TO
CHARGE STATE INDICATION DEVICE — S217

CLOSE CIRCUIT OPENING / CLOSING SWITCH — S218

END

## FIG.5

T VALUE DETERMINING TABLE

## FIG. 6

BATTERY TEMPERATURE 0°C

FOLLOWING A 5-SEC CHARGE AT 60A

FOLLOWING A 5-SEC DISCHARGE AT 60A

ACTUAL BATTERY SOC

SOC% CALCULATED IN CORRESPONDENCE TO BATTERY VOLTAGE

LENGTH OF TIME ELAPSING AFTER CHARGE / DISCHARGE (S)

## FIG. 7

BATTERY TEMPERATURE 25°C

SOC% CALCULATED IN CORRESPONDENCE TO BATTERY VOLTAGE

FOLLOWING A 5-SEC CHARGE AT 60A

FOLLOWING A 5-SEC DISCHARGE AT 60A

ACTUAL BATTERY SOC

LENGTH OF TIME ELAPSING AFTER CHARGE / DISCHARGE (S)

## FIG. 8

BATTERY TEMPERATURE 40°C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H8106927 A
- US 5773962 A